(19) Europäisches Patentamt

European Patent Office

Office européen des brevets

(11) **EP 4 492 689 A1**

(12) **EUROPEAN PATENT APPLICATION**

(43) Date of publication:
**15.01.2025  Bulletin 2025/03**

(51) International Patent Classification (IPC):
*H03L 7/093* $^{(2006.01)}$        *H03L 7/099* $^{(2006.01)}$

(21) Application number: **23185274.0**

(52) Cooperative Patent Classification (CPC):
**H03L 7/099; H03L 7/093**

(22) Date of filing: **13.07.2023**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **NXP B.V.**
**5656 AG Eindhoven (NL)**

(72) Inventors:
• **Velandia Torres, Javier Mauricio**
  **5656 AG Eindhoven (NL)**

• **Darfeuille, Sebastien**
  **5656 AG Eindhoven (NL)**
• **Gsöls, Patrick Dominik**
  **5656 AG Eindhoven (NL)**

(74) Representative: **Krott, Michel**
**NXP B.V.**
**Intellectual Property & Licensing**
**High Tech Campus 60**
**5656 AG Eindhoven (NL)**

Remarks:
Amended claims in accordance with Rule 137(2) EPC.

(54) **ELECTRONIC CONTROL DEVICE**

(57)  Electronic control device (200), comprising:
- a first input (201) for a control voltage ($V_{tune}$) of a voltage controlled device (200);
- a second input (202) for a reference control voltage ($V_{tune0}$) of the voltage controlled device (200); and
- an output (203), wherein

- the electronic control device (200) is configured to provide a bias current change ($\Delta I_B$) via the output (203) to the voltage controlled device (200) in order to maintain a level of the control voltage ($V_{tune}$) inside a specified range.

Fig. 4

**EP 4 492 689 A1**

**Description**

TECHNICAL FIELD

The present disclosure relates to an electronic control device. Furthermore, the present disclosure relates to a method of operating an electronic control device.

BACKGROUND

Voltage-Controlled Oscillators (LC-VCOs) are state of the art in high performance PLLs because of their low-phase noise properties. The frequency of the VCO is fine-tuned by the PLL acting on a voltage-controlled capacitor. The input is known as control voltage $V_{tune}$. Occasionally, the VCO also integrates coarse tunability with digital-controlled capacitors to extend the operation range. Such digitally-controlled capacitors are calibrated before the PLL can start controlling and fine-tuning the frequency. Due to limited range of control voltage to correct frequency drift in the LC-VCO, applications running with a locked PLL are often restricted in their ability to accommodate temperature drift or long continuous operation without a recalibration of the digitally-controlled capacitors (if they exist). Indeed, a temperature drift causes a change in the oscillator's output frequency when keeping the control voltage constant in open-loop configuration, whereas in closed-loop configuration the loop tries to counteract the frequency change by adjusting the control voltage as far as the PLL's supply (VDD) range allows. Therefore, the tuning voltage turns out to be the bottleneck, especially as VDD room becomes lower with more advanced CMOS technology nodes, leaving the loop less room for counteraction. Consequently, strong temperature changes of the already locked PLL can rapidly bring the PLL out of lock.

Using a second point injection in the oscillator to compensate the drift via additional varactors is possible but it results in additional parasitics in the LC tank which can limit the tuning range, limiting the maximum operating frequency, increasing the power or impacting the overall noise.

Conventional bias-current based compensation techniques use a combination of PTAT/CTAT (proportional to absolute temperature/complementary to absolute temperature) currents fed to a VCO's bias current node for counteracting the temperature-induced frequency drift. This kind of compensation solely relies on the current's temperature coefficient. Hence, the temperature, which can be seen as a second reference input (besides the tuning voltage), acts on a system in open-loop configuration. Any frequency error that may occur due to improper bias current adaption can therefore only be compensated by the main loop of the PLL (via tuning voltage adaption).

US 9 413 366 B2 discloses apparatus and methods for phase-locked loops with temperature compensated calibration voltage.

US 8 803 616 B2 discloses temperature compensation and coarse tune bank switches in a low phase noise VCO.

US 8 466 750 B2 discloses VCO utilizing an auxiliary varactor with temperature dependent bias.

SUMMARY

A first aspect of the present disclosure is directed to an electronic control device, comprising:

- a first input for a control voltage of a voltage controlled device;
- a second input for a reference control voltage of the voltage controlled device; and
- an output, wherein
- the electronic control device is configured to provide a bias current change via the output to the voltage controlled device in order to maintain a level of the control voltage inside a specified range.

A further aspect of the present disclosure is directed to a method of operating an electronic control device, comprising the steps:

- receiving a control voltage and a reference control voltage of a voltage controlled device; and
- providing a bias current change to the voltage controlled device in such a way, that a level of the control voltage is kept inside a specified range.

In this way, by means of the proposed electronic control device and the proposed method, the voltage controlled device is at least partially controlled by means of a bias current. Advantageously, no additional control elements are required, which in effect results in an effective temperature desensitization of the voltage controlled device. No needs exist to design the voltage controlled device in order to incorporate the control characteristics by means of the electronic control device.

In one or more embodiments, the electronic control device is configured to minimize a difference between the control voltages.

In one or more embodiments, the control voltage is implemented within a first control loop of the voltage controlled device, wherein the electronic control device is implemented within an additional control loop of the voltage controlled device. In this way, a loop based arrangement is implemented, which can easily be controlled.

In one or more embodiments, the control loops have different time constants, wherein the first control loop has a fast behavior to track changes affecting a frequency synthesizer, wherein the additional control loop has a slow behavior in order to follow temperature variations. In this context, a "fast behavior" is typically in the microsecond range and a "slow behavior" is typically in the range of milliseconds or more.

In one or more embodiments, the electronic control device is configured to correct a temperature drift of the voltage controlled device by adapting the control voltage.

In one or more embodiments, the electronic control device is configured to maintain the control voltage in a dependency of an electric supply voltage. In this way, a specified operational characteristics of the electronic control device is supported.

In one or more embodiments, the electronic control device is configured to maintain the control voltage inside a specified range with respect to the electric supply voltage.

In one or more embodiments, the electronic control device is configured to control an LC-oscillator-based frequency synthesizer.

In one or more embodiments, the electronic control device comprises the following blocks, which are functionally serially coupled with each other: difference amplifier, low pass filter, Voltage-To-Current (V2I)-converter. By means of the low pass filter, control loop characteristics (e.g. with respect to time constants) may be designed properly.

In one or more embodiments, the electronic control device is configured to artificially generate an additional VCO-gain by measuring a tuning voltage shift, converting the voltage shift into a current and feeding the resulting bias current change to a voltage controlled oscillator of the voltage controlled device.

In one or more embodiments, the electronic control device is configured to derive, with the VCO's bias current sensitivity a transconductance, needed in the voltage-to-current converter in order to implement the temperature-compensation/artificial VCO gain.

BRIEF DESCRIPTION OF DRAWINGS

The above discussion/summary is not intended to describe each embodiment or every implementation of the present disclosure. The drawings and detailed description that follow also exemplify various embodiments. The aspects defined above and further aspects of the present disclosure are apparent from the examples of embodiment to be described hereinafter with reference to the appended drawings, which are explained with reference to the examples of embodiment. However, the disclosure is not limited to the examples of embodiment.

All illustrations in the drawings are schematical. It is noted that in different figures, similar or identical elements or features are provided with the same reference signs or with reference signs that are different from the corresponding reference signs only within the first digit. In order to avoid unnecessary repetitions, elements or features which have already been elucidated with respect to a previously described embodiment are not elucidated again at a later position of the description.

Various example embodiments may be more completely understood in consideration of the following detailed description in connection with the accompanying drawings, in which:

FIG. 1      shows a conventional control loop-based frequency synthesizer;

FIG. 2      is a diagram illustrating a control voltage to control a frequency in dependence of temperature;

FIG. 3      are diagrams showing the parameters: temperature, frequency and control voltage of the conventional system in FIG 1;

FIG. 4      is a diagram with an embodiment of a proposed electronic control device;

FIG. 5      is a diagram showing a LC-VCO frequency characteristic curve with control voltage and bias current dependency;

FIG. 6      are diagrams showing the parameters: temperature, frequency and control voltage with the proposed method in FIG 4; and

FIG. 7      is a diagram with a flow of the proposed method.

While various embodiments discussed herein are amenable to modifications and alternative forms, aspects thereof have been shown by way of example in the drawings and will be described in detail. It should be understood, however, that the intention is not to limit the disclosure to the particular embodiments described. On the contrary, the intention is to cover all modifications, equivalents, and alternatives falling within the scope of the disclosure including aspects defined in the claims. In addition, the term "example" as used throughout this application is only by way of illustration and not limitation.

DESCRIPTION OF EMBODIMENTS

Aspects of the present disclosure are believed to be applicable to a variety of different types of devices, apparatuses, systems and methods involving voltage controlled devices formed as frequency synthesizers. While not necessarily so limited, various aspects may be appreciated through the following discussion of non-limiting examples which use exemplary contexts.

In the following description various specific details are set forth to describe specific examples presented herein. It should be apparent to one skilled in the art, however, that one or more other examples and/or variations of these examples may be practiced without all the specific details given below. In other instances, well known features have not been described in detail so as not to obscure the description of the examples herein. For ease of illustration, the same reference signs may be used in different diagrams to refer to the same elements or additional instances of the same element. Also, although aspects and features may in some cases be described in individual figures, it will be appreciated that features from one figure or embodiment can be combined with features of another figure or embodiment even though the combination is not explicitly shown or explicitly described as a combination.

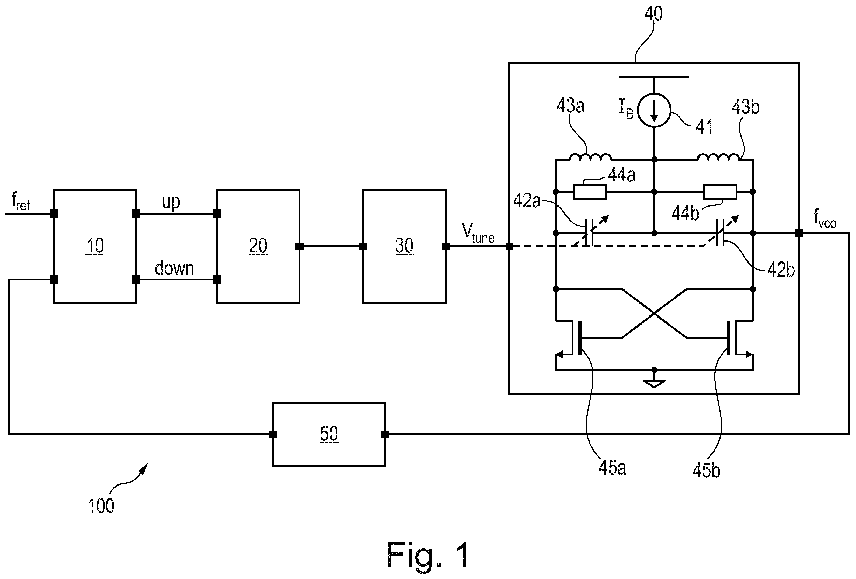

Almost every system which relies on clock-signals uses PLLs at some point for frequency synthesis, skew suppression, jitter reduction or clock recovery. In modern transceiver/receiver systems there exists a need of frequency synthesizers, implemented e.g. as Phase Locked Loops (PLLs) with LC-VCOs for low noise, as exemplary shown in FIG. 1. One recognizes a block diagram of a conventional voltage controlled device 100 formed as a frequency synthesizer with a main control loop. The frequency synthesizer comprises a phase frequency detector 10 which receives a reference clock signal $f_{ref}$ and which provides signals "up", "down" to a downstream charge pump 20. The charge pump 20 provides an output signal to a loop filter 30, which integrates input electric charges from the charge pump 20 and which provides an electric control voltage $V_{tune}$ to a voltage controlled oscillator 40 (LC-VCO) with a bias current source 41. The voltage controlled oscillator 40 comprises variable capacitors (varactors) 42a, 42b, which are controlled via the control voltage $V_{tune}$.

Moreover, the voltage-controlled oscillator 40 comprises inductors 43a, 43b, transistors 45a, 45b and parasitic resistors 44a, 44b which are interconnected in a manner known per se. At an output of the voltage controlled oscillator 40 a signal with a frequency fvco is provided, which is supplied to a divider element 50 which provides a signal with a divided frequency fvco to a second input of the phase frequency detector 10. In this way, the frequency synthesizer is controlled by a main loop having the above mentioned components including a charge pump 20 (so called PLL type II-arrangement). Due to temperature variations and the temperature dependency of the elements of the LC-VCO the frequency fvco will vary depending on the temperature for a given fixed control voltage.

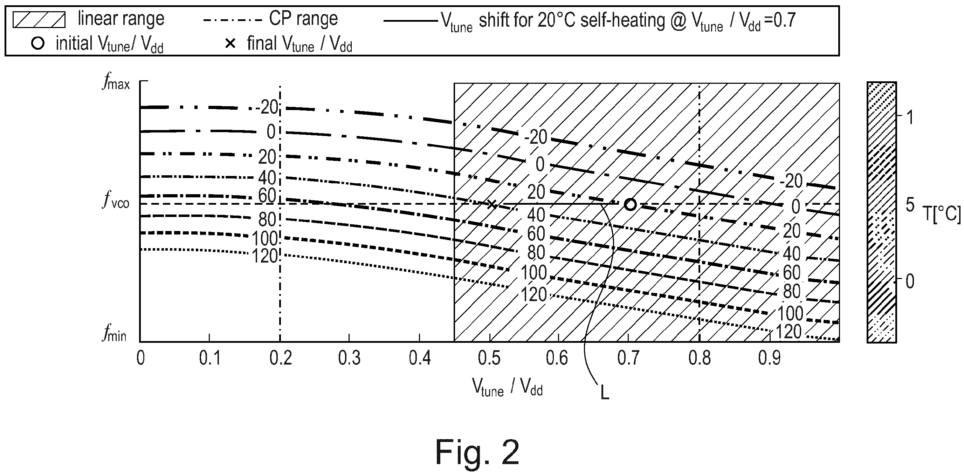

FIG. 2 depicts an example of a typical LC-VCO frequency tuning curve, where the varactors 42a, 42b are used for controlling the frequency fvco of the frequency synthesizer. In general, any type of MOS varactor 42a, 42b can be used, it may simply affect the polarity of the frequency gain which is then taken into account when connecting the other blocks of the frequency synthesizer. Due to the movement towards large SoCs in more advanced technology nodes the on-chip temperature gradients become larger and larger, causing a dramatic amount of temperature-induced frequency variation which go beyond what the control loop of the frequency synthesizer could compensate due to tuning voltage range limitations. This could, in a worst case scenario, result in an unlocked frequency synthesizer, meaning that a self-heating effect is that high that there is no longer an intersection between a line L (constant frequency line) and the frequency curves shown in FIG. 2.

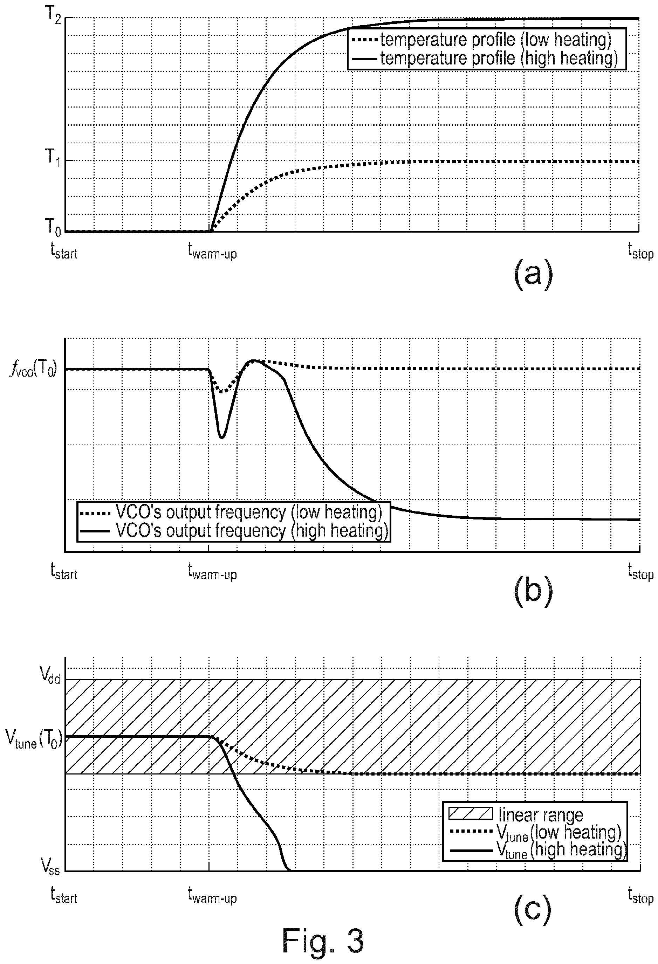

This effect becomes even more obvious in the time-domain as depicted in FIG. 3. An assumed temporal temperature profile is shown in FIG. 3A. For simplicity, the system is not experiencing any temperature change during start-up. At some point in time, the system starts to heat up, which leads to reduced VCO output frequency as shown in FIG. 3b and which the frequency synthesizer corrects by adjusting the electric control voltage $V_{tune}$. FIG. 3b shows two temporal courses of the frequency fvco for low heating (dotted curve) and high heating (solid curve). For noise reasons, LC-VCOs do have low VCO-gain Kvco, which means that this correction process of the frequency synthesizer only works within a certain temperature range.

In comparison, FIG. 3c shows a transient tuning voltage reaction of the control loop of the frequency synthesizer, whereas FIG. 2 shows what happens with the control voltage $V_{tune}$ in locked mode, when the temperature changes and the frequency of the voltage controlled oscillator 40 drifts away from the original calibration temperature (needed static voltage shift to keep locked condition). Eventually the voltage rails and the charge pump 20 cannot operate anymore. As a result, the frequency synthesizer goes out of lock and the application needs to recalibrate the VCO bands. The effect becomes stronger if the range for the control voltage $V_{tune}$ is smaller like in modern advanced technology nodes. Since recalibration of the coarse-tuning capacitors (if they exist) in the voltage controlled oscillator 40 during online operation is in most cases not possible, because thereby one would create frequency jumps when switching capacitors on and off, it is proposed to implement an additional loop-based circuitry to compensate the temperature-induced frequency shift.

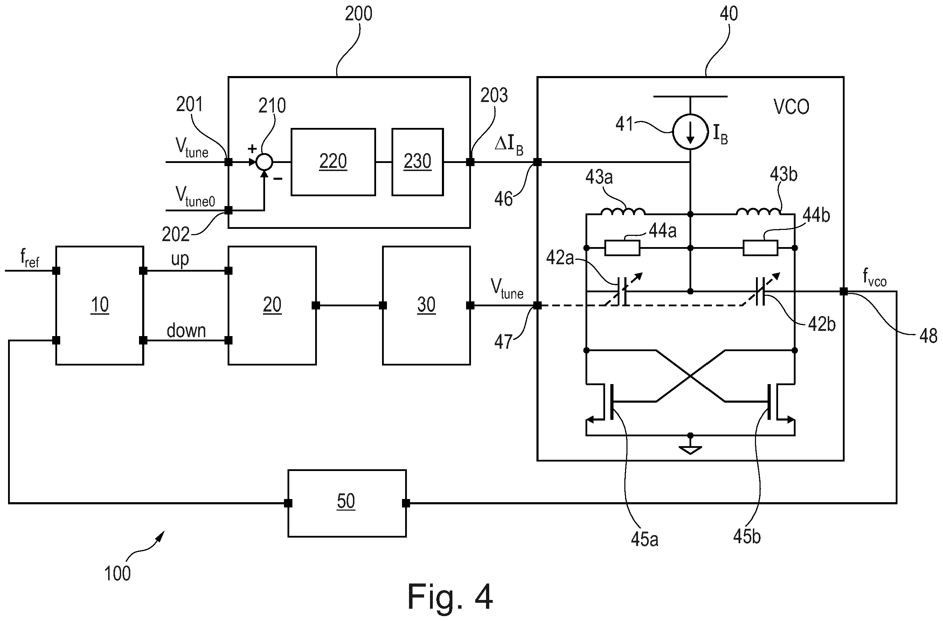

FIG. 4 presents an exemplary voltage controlled device 100 implemented as frequency synthesizer with a cross-coupled voltage controlled oscillator 40 and a proposed electronic control device 200 which is based on a bias-current adaption technique implemented with a V2I-converter (voltage-to-current converter) 230. With the proposed bias-current adaption technique it is possible to use an electric bias current $I_B$ (VCO's bias current) as a second tuning point to control the oscillator frequency via a secondary slow loop inside the frequency synthesizer. It is well known that cross-coupled LC-VCOs do have a characteristic of a bias current dependent output frequency fvco and how compensation circuit parameters can be calculated in this context. Therefore, no more details are given in this respect. At the output 48 of the voltage controlled oscillator 40 a signal with a frequency fvco is provided, which is supplied to the divider element 50 which provides a signal with a divided frequency fvco to the second input of the phase frequency detector 10.

The two control loops have different time constants, wherein the first control loop has a fast behavior, typically in the range of microseconds, wherein the additional control loop has a slow behavior relative to the first loop in order to follow temperature variations (e.g. with time constants of milliseconds to seconds). In effect, the voltage controlled frequency synthesizer is controlled by a first control loop and additionally at least partially by means of the proposed electronic control device 200.

The proposed bias-current adaption technique by means of V2I-converter 230 is not limited to analog PLLs (like in FIG. 1) but it can also be applied to digital PLLs, where the control voltage $V_{tune}$ is replaced by a digitalized control word and the voltage controlled-capacitor is replaced by a discrete capacitor array digitally-controlled by the control word. The electronic control device 200 comprises three main building blocks or stages, respecttively. A first stage is a difference amplifier 210, which compares the control voltage $V_{tune}$, which is supplied at a first input 201 of the electronic control device 200 and at a second input 47 of the voltage controlled oscillator 40 and which is dynamically adjusted by the main control loop of the frequency synthesizer, against the reference control voltage $V_{tune0}$ used to (e.g. initially) calibrate the output frequency of the voltage controlled oscillator 40 for a specific temperature $T_0$. The reference control voltage $V_{tune0}$ can be seen as a reference input to the electronic control device 200. In an ideal world the control voltage $V_{tune}$ will perfectly converge to the reference control voltage $V_{tune0}$, which is supplied at a second input 202 of the electronic control device 200 if everything is in steady-state. Downstream of the difference amplifier 210 is a low-pass filter 220 which slows down the second control loop being implemented by means of the electronic control device 200. This additional time constant has multiple reasons.

Firstly, the second closed control loop should be robust against process variations. Furthermore, fast tuning voltage changes, which are not temperature-induced, shall not reflect on the VCO's bias current $I_B$. The electronic control device 200 shall be as transparent as possible, which means that it should ideally not change the PLL's open- and closed-loop characteristic. Lastly, the V2I converter 230 is responsible for converting a temperature-induced tuning voltage change $\Delta V_{tune}$ into a corresponding bias current change $\Delta I_B$, which is supplied at an output 203 of the electronic control device 200 and at a first input 46 of the voltage controlled oscillator 40. Possibilities for calculating the V2I-converter's transconductance $G_m$ as such are well known.

In effect, the electronic control device 200 is configured to minimize a difference between the control voltages $V_{tune}$ and $V_{tune0}$.

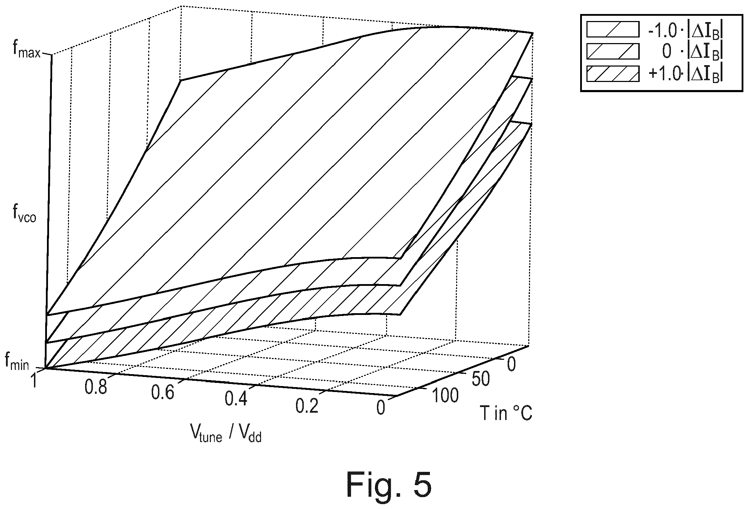

The ability to adjust the bias current $I_B$ dynamically, practically results in the creation of a second control branch for the voltage controlled oscillator 40 which results in a three-dimensional VCO frequency characteristic curve, as exemplary shown in FIG. 5, which shows a LC-VCO frequency characteristic curve with tuning voltage and bias current dependency over temperature. The proposed electronic control device 200 exploits the temperature-induced tuning voltage shift $\Delta V_{tune}$ and converts it into a proportional bias current change $\Delta I_B$. An underlying idea is to artificially generate an additional VCO-gain $K_{vco}^{(comp)}$. This can be done by measuring the tuning voltage shift $\Delta V_{tune}$, converting it into a current and feeding this current change to the LC-VCO. From a behavioral point of view one needs a voltage-to-current (V2I) converter 230 with a proper transconductance $G_m$.

The necessary transconductance $G_m$ of the voltage-to-current converter 230, for a fully temperature compensated voltage controlled oscillator 40, is derived from the VCO's two-dimensional frequency curve, as depicted in FIG. 2. First, one needs to extract the maximum frequency shift caused within the VCO's temperature range:

$$\Delta f_{vco}^{(max)} = \max\big(\max\big(f_{vco}(T, V_{tune})\big) - \min\big(f_{vco}(T, V_{tune})\big)\big) \qquad (1)$$

A full temperature compensation of the voltage-controlled device 100 is in most cases not necessary. Often it is enough if the VCO's sensitivity regarding temperature is reduced. Hence, one could simply set $\Delta f_{vco}^{(max)}$ to a value which corresponds to a certain temperature range which is wanted to cover without having to recalibrate the voltage controlled oscillator 40.

Since frequency synthesizers formed as PLLs do have tuning voltage limitations, it should be taken into account how much the tuning voltage can be varied around the calibrated operating point at the reference voltage $V_{tune0}$.

$$\Delta V_{tune}^{(max)}$$
$$= \begin{cases} V_{tune0} - V_{tune}^{(min)}, & \text{sign}\left(\left.\dfrac{df_{vco}}{dT}\right|_{T_0, V_{tune0}}\right) = \text{sign}\left(\left.\dfrac{df_{vco}}{dV_{tune}}\right|_{T_0, V_{tune0}}\right) \\ V_{tune}^{(max)} - V_{tune0}, & \text{sign}\left(\left.\dfrac{df_{vco}}{dT}\right|_{T_0, V_{tune0}}\right) \neq \text{sign}\left(\left.\dfrac{df_{vco}}{dV_{tune}}\right|_{T_0, V_{tune0}}\right) \end{cases} \quad (2)$$

With equations (1) and (2) one can calculate the temperature-compensation VCO gain $K_{vco}^{(comp)}$ as

$$K_{vco}^{(comp)} = \text{sign}\left(\left.\frac{df_{vco}}{dV_{tune}}\right|_{T_0, V_{tune0}}\right) \cdot \frac{\Delta f_{max}}{\Delta V_{tune}^{(max)}} \cdot \quad (3)$$

From a change in the VCO's bias current $I_B$ which leads to shifted frequency curves, it can be deduced how sensitive the VCO frequency is to changes in the bias current $I_B$. With the VCO's bias current sensitivity $\dfrac{df_{vco}}{dI_B}$ (assuming constant sign for all current sensitivity values) and equation (3) one can derive the transconductance $G_m$ needed in the voltage-to-current converter 230 in order to implement the proposed temperature-compensation/artificial VCO gain:

$$G_m = K_{vco}^{(comp)} \cdot \left(\text{sign}\left(\left.\frac{df_{vco}}{dI_B}\right|_{T_0, V_{tune0}, I_{B0}}\right) \cdot \min\left(\left|\frac{df_{vco}}{dI_B}\right|\right)\right)^{-1} \quad (4)$$

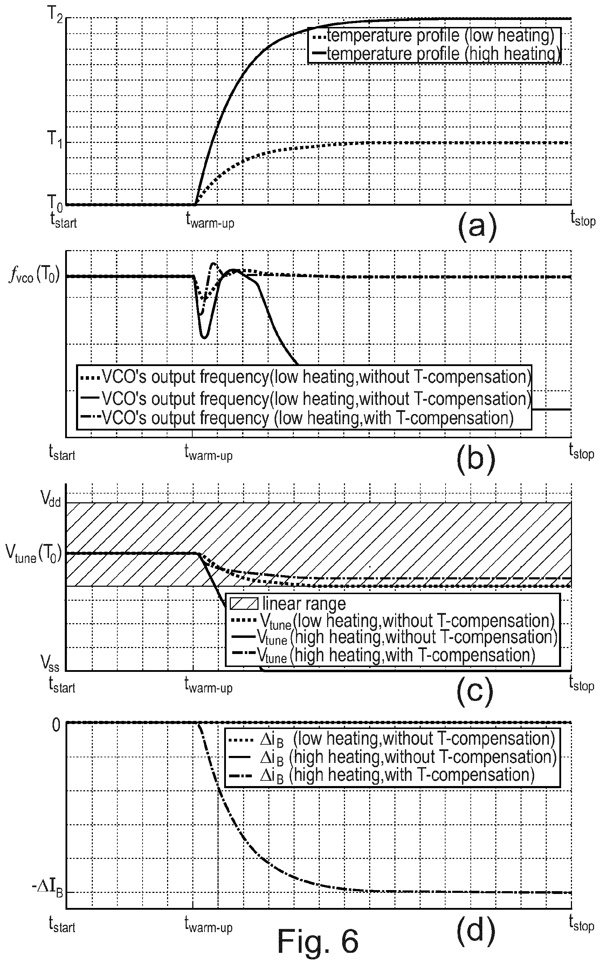

Transient plots shown in FIG. 6 visualize the action of the whole temperature desensitized frequency oscillator if it is exposed to low and high heating (see FIG 6a). As visible from the VCO's output frequency fvco (see FIG. 6b), the frequency synthesizer can no longer maintain locked state without countermeasures if it is strongly heated (solid curve). This happens due to the tuning voltage limitation of the system (solid curve in FIG. 6c). In comparison, at low heating (dotted curve in FIG. 6c), correction via the electric control voltage $V_{tune}$ is sufficient to obtain a locked frequency synthesizer.

The electronic control 200 provides sinks or sources current from the bias current node of the VCO (as shown in FIG. 6d), providing a locked PLL state by adjusting the output frequency (dashed curve in FIG. 6b) of the oscillator without reaching the limits of the tuning voltage $V_{tune}$ (dashed curve in FIG. 6c).

In an embodiment, the electronic control device 200 may be configured to maintain the control voltage $V_{tune}$ in a dependency of an electric supply voltage $V_{dd}$.

In an embodiment, the electronic control device 200 may be configured to maintain the control voltage $V_{tune}$ inside a specified range with respect to the electric supply voltage $V_{dd}$.

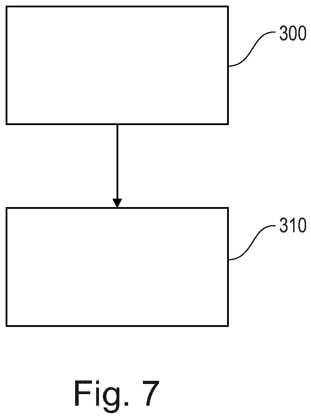

FIG. 7 shows a flow of a proposed method of operating an electronic control device 200.

In a step 300 a control voltage $V_{tune}$ and a reference control voltage $V_{tune0}$ of a voltage controlled device 100 are received.

In a step 310 a bias current change $\Delta I_B$ is provided to the voltage controlled device 100 in such a way, that a level of the control voltage $V_{tune}$ is kept inside a specified range.

The proposed temperature compensation device exploits in its secondary control loop the properties of a closed-loop system. The higher the open-loop gain of the amplifiers used inside the difference amplifier stage of the electronic control device 200 are, the lower the remaining error, that has to be controlled by the control voltage $V_{tune}$ in order to keep the VCO's output frequency stable.

The proposed electronic control device 200 can be easily added to existing PLLs without any change inside the sensitive oscillator core (LC-tank). The temperature compensation is done in a secondary slow control loop in a closed loop fashion in order to make it robust against process variations, and it is at the same time not very intrusive from a PLL topology perspective as this only comes as an add-on element to the existing circuit. The original building blocks do not require particular re-design and the main loop characteristics are not affected.

The proposed electronic control device can be used e.g. as part of any LC-VCO-based PLL that requires uninterrupted operation while in the presence of temperature variations that could be too large to handle just from the oscillator tuning voltage. UWB ICs are good candidates for that, but several other ICs especially in the field of wireless communications could also benefit from the proposed control device.

Summarizing, a temperature desensitization technique for RF LC-VCO based PLLs by controlling the oscillator biasing in closed loop is proposed, which allows the PLL to stay in lock over large temperature range, without the need to recalibrate the oscillator.

As another example, where the specification may make reference to a "first" type of structure, a "second" type of structure, where the adjectives "first" and "second" are not used to connote any description of the structure or to provide any substantive meaning; rather, such adjectives are merely used for English-language antecedence to differentiate one such similarly-named structure from another similarly-named structure.

Based upon the above discussion and illustrations, those skilled in the art will readily recognize, that various modifications and changes may be made to the various embodiments without strictly following the exemplary embodiments and applications illustrated and described herein. For example, methods as exemplified in the Figures may involve steps carried out in various orders, with one or more aspects of the embodiments herein retained, or may involve fewer or more steps.

It should be noted that the term "comprising" does not exclude other elements or steps and "a" or "an" does not exclude a plurality. Also elements described in association with different embodiments may be combined. It should also be noted, that reference signs in the claims should not be construed as limiting the scope of the claims.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

It has to be noted that embodiments have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this application.

Reference signs:

| | |
|---|---|
| 10 | phase frequency detector |
| 20 | charge pump |
| 30 | loop filter |
| 40 | voltage controlled oscillator (VCO) |
| 41 | bias current source |
| 42a, 42b | I-MOS varactor |
| 43a, 43b | inductor |
| 44a, 44b | parasitic resistor |
| 45a, 45b | transistor |
| 46 | 1st input |
| 47 | 2nd input |
| 48 | output |
| 50 | divider element |
| 100 | voltage controlled device |
| 200 | electronic control device |
| 201 | 1st input |
| 202 | 2nd input |

| 203 | output |
|---|---|
| 300, 310 | method steps |
| $f_{ref}$ | reference frequency |
| fvco | oscillator frequency |
| L | line |
| $\Delta I_B$ | bias current change |
| $I_B$ | bias current |
| $V_{dd}$ | supply voltage |
| $V_{tune}$ | control voltage |
| $V_{tune0}$ | reference control voltage |

**Claims**

1. Electronic control device (200), comprising:

   - a first input (201) for a control voltage ($V_{tune}$) of a voltage controlled device (200);
   - a second input (202) for a reference control voltage ($V_{tune0}$) of the voltage controlled device (200); and
   - an output (203), wherein
   - the electronic control device (200) is configured to provide a bias current change ($\Delta I_B$) via the output (203) to the voltage controlled device (200) in order to maintain a level of the control voltage ($V_{tune}$) inside a specified range.

2. Electronic control device (200) according to claim 1, wherein the electronic control device (200) is configured to minimize a difference between the control voltages ($V_{tune}$, $V_{tune0}$).

3. Electronic control device (200) according to claim 1 or 2, wherein the control voltage is implemented within a first control loop of the voltage controlled device (100), wherein the electronic control device (200) is implemented within an additional control loop of the voltage controlled device (100).

4. Electronic control device (200) according to claim 3, wherein the control loops have different time constants, wherein the first control loop has a fast behavior to track changes affecting a frequency synthesizer, wherein the additional control loop has a slow behavior in order to follow temperature variations.

5. Electronic control device (200) according to one of the preceding claims, wherein the electronic control device (200) is configured to correct a temperature drift of the voltage controlled device (100) by adapting the control voltage ($V_{tune}$).

6. Electronic control device (200) according to one of the preceding claims, wherein the electronic control device (200) is configured to maintain the control voltage ($V_{tune}$) in a dependency of an electric supply voltage ($V_{dd}$).

7. Electronic control device (200) according to claim 6, wherein the electronic control device (200) is configured to maintain the control voltage ($V_{tune}$) inside a specified range with respect to the electric supply voltage ($V_{dd}$).

8. Electronic control device (200) according to any of the preceding claims, wherein the electronic control device (200) is configured to control an LC-oscillator based frequency synthesizer.

9. Electronic control device (200) according to any of the preceding claims, comprising the following blocks, which are functionally serially coupled with each other: difference amplifier (210), low pass filter (220), Voltage-to-Current, V2I,-converter (230).

10. Electronic control device (200) according to claim 9, wherein the control device (200) is configured to artificially generate an additional VCO-gain $(K_{vco}^{(comp)})$ by measuring a tuning voltage shift ($\Delta V_{tune}$), converting the voltage shift ($\Delta V_{tune}$) into a current and feeding the resulting bias current change ($\Delta I_B$) to a voltage controlled oscillator (40) of the voltage controlled device (100).

11. Electronic control device (200) according to claim 10, wherein the control device (200) is configured to derive, with the VCO's bias current sensitivity $(\frac{df_{vco}}{dI_B})$ a transconductance, $G_m$, needed in the voltage-to-current converter (230) in order to implement the temperature-compensation/artificial VCO gain ( $K_{vco}^{(comp)}$ ).

12. Method for operating an electronic control device (200), comprising the steps:

- receiving a control voltage ($V_{tune}$) and a reference control voltage ($V_{tune0}$) of a voltage controlled device (100); and
- providing a bias current change ($\Delta I_B$) to the voltage controlled device (100) in such a way, that a level of the control voltage ($V_{tune}$) is kept inside a specified range.

**Amended claims in accordance with Rule 137(2) EPC.**

1. Electronic control device (200), comprising:

- a first input (201) configured to receive a control voltage ($V_{tune}$) of a voltage controlled oscillator (40);
- a second input (202) configured to receive a reference control voltage ($V_{tune0}$) of the voltage controlled oscillator (40); and
- an output (203), wherein

the electronic control device (200) is configured to provide a temperature-induced bias current change ($\Delta I_B$) of the voltage controlled oscillator (40) via the output (203) to the voltage controlled oscillcator (40) in order to maintain a level of the control voltage ($V_{tune}$) inside a specified range whereinwherein the electronic control device (200) is configured to minimize a difference between the control voltage ($V_{tune}$) and the reference control voltage ($V_{tune0}$).

2. Electronic control device (200) according to claim 1 , wherein the control voltage is implemented within a first control loop of the voltage controlled device (100), wherein the electronic control device (200) is implemented within an additional control loop of the voltage controlled device (100).

3. Electronic control device (200) according to claim 2, wherein the control loops have different time constants, wherein the first control loop has a fast behavior to track changes affecting a frequency synthesizer, wherein the additional control loop has a slow behavior in order to follow temperature variations.

4. Electronic control device (200) according to one of the preceding claims, wherein the electronic control device (200) is configured to correct a temperature drift of the voltage controlled oscillator (40) by adapting the control voltage ($V_{tune}$).

5. Electronic control device (200) according to one of the preceding claims, wherein the electronic control device (200) is configured to maintain the control voltage ($V_{tune}$) in a dependency of an electric supply voltage ($V_{dd}$).

6. Electronic control device (200) according to claim 5, wherein the electronic control device (200) is configured to maintain the control voltage ($V_{tune}$) inside a specified range with respect to the electric supply voltage ($V_{dd}$).

7. Electronic control device (200) according to any of the preceding claims, wherein the electronic control device (200) is configured to control an LC-oscillator based frequency synthesizer.

8. Electronic control device (200) according to any of the preceding claims, comprising the following blocks, which are functionally serially coupled with each other: difference amplifier (210), low pass filter (220), Voltage-to-Current, V2I,-converter (230).

9. Electronic control device (200) according to claim 8, wherein the control device (200) is configured to artificially generate an additional VCO-gain ( $K_{vco}^{(comp)}$ ) by measuring a tuning voltage shift ($\Delta V_{tune}$), converting the voltage shift ($\Delta V_{tune}$) into a current and feeding the resulting bias current change ($\Delta I_B$) to the voltage controlled oscillator (40) of the voltage controlled device (100).

10. Electronic control device (200) according to claim 9, wherein the control device (200) is configured to derive, with the VCO's bias current sensitivity ( $\frac{df_{vco}}{dI_B}$ ) a transconductance, $G_m$, needed in the voltage-to-current converter (230) in order to implement the temperature-compensation/artificial VCO gain ( $K_{vco}^{(comp)}$ ).

11. Method for operating an electronic control device (200), comprising the steps:

- receiving a control voltage ($V_{tune}$) and a reference control voltage ($V_{tune0}$) of a voltage controlled oscillator (40); and
- providing a temperature-induced bias current change ($\Delta I_B$) to the voltage controlled oscillator (40) in such a way, that a level of the control voltage ($V_{tune}$) is kept inside a specified range, wherein a difference between the control voltage ($V_{tune}$) and the reference control voltage ($V_{tune0}$) is minimized.

Fig. 1

Fig. 2

(a)

(b)

(c)

Fig. 3

Fig. 4

Fig. 5

EP 4 492 689 A1

Fig. 6

Fig. 7

Europäisches
Patentamt
European
Patent Office
Office européen
des brevets

# EUROPEAN SEARCH REPORT

**Application Number**

EP 23 18 5274

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 329 883 B1 (PACOUREK JOHN ROBERT [US]) 11 December 2001 (2001-12-11) * column 5, line 4 - column 6, line 23; figure 3 * * column 6, line 24 - line 65; figure 4 * ----- | 1-12 | INV. H03L7/093 H03L7/099 |
| X | US 8 432 204 B1 (CHERN CHAN-HONG [US] ET AL) 30 April 2013 (2013-04-30) * column 2, line 30 - column 4, line 20; figures 1,2 * * column 4, line 34 - line 60; figures 4,5 * ----- | 1-12 | |
| X | US 2007/173219 A1 (KIM KWANG-HO [KR] ET AL) 26 July 2007 (2007-07-26) * paragraph [0079] - paragraph [0087]; figure 9 * ----- | 1-8,12 | |
| | | | TECHNICAL FIELDS SEARCHED (IPC) H03L |

The present search report has been drawn up for all claims

| Place of search | Date of completion of the search | Examiner |
|---|---|---|
| The Hague | 7 December 2023 | Aouichi, Mohamed |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 18 5274

This annex lists the patent family members relating to the patent documents cited in the above-mentioned European search report.
The members are as contained in the European Patent Office EDP file on
The European Patent Office is in no way liable for these particulars which are merely given for the purpose of information.

07-12-2023

| Patent document cited in search report | | Publication date | Patent family member(s) | | Publication date |
|---|---|---|---|---|---|
| US 6329883 | B1 | 11-12-2001 | NONE | | |
| US 8432204 | B1 | 30-04-2013 | CN | 103199857 A | 10-07-2013 |
| | | | US | 8432204 B1 | 30-04-2013 |
| US 2007173219 | A1 | 26-07-2007 | KR | 100712547 B1 | 02-05-2007 |
| | | | US | 2007173219 A1 | 26-07-2007 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9413366 B2
- US 8803616 B2

- US 8466750 B2